# EUROPEAN PATENT SPECIFICATION

(11) **EP 2 009 713 B1**
(45) Date of publication and mention of the grant of the patent: **18.04.2018**
(21) Application number: 08158812.1
(22) Date of filing: 23.06.2008
(51) Int. Cl.: H01L 51/44

(54) **Nanostructured solar cell**
Nanostrukturierte Solarzelle
Cellule solaire nanostructurée

(30) Priority: 26.06.2007 US 768690
(43) Date of publication of application: 31.12.2008
(73) Proprietor: Honeywell International Inc., Morris Plains, NJ 07950 (US)
(72) Inventor: Liu, Yue, Plymouth, MN 55447 (US)
(74) Representative: Houghton, Mark Phillip

(56) References cited:
- WO-A2-2006/073562
- RAFFAELLE R P ET AL: "Quantum dot-single wall carbon nanotube complexes for polymeric solar cells", CONFERENCE RECORD OF THE THIRTY-FIRST IEEE PHOTOVOLTAIC SPECIALIST CONFERENCE (IEEE CAT. NO. 05CH37608) IEEE PISCATAWAY, NJ, USA,, 3 January 2005 (2005-01-03), pages 74-77, XP010822653, DOI: 10.1109/PVSC.2005.1488072 ISBN: 978-0-7803-8707-2
- SHEN Q ET AL: "Photoacoustic and photoelectrochemical characterization of CdSe-sensitized TiO2 electrodes composed of nanotubes and nanowires", THIN SOLID FILMS, ELSEVIER-SEQUOIA S.A. LAUSANNE, CH, vol. 499, no. 1-2, 21 March 2006 (2006-03-21), pages 299-305, XP025006476, ISSN: 0040-6090, DOI: 10.1016/J.TSF.2005.07.019 [retrieved on 2006-03-21]

## Description

### Background

The invention pertains to electrical power devices and particularly to power generating devices. More particularly, the invention pertains to solar-based power generating devices.

### Summary

The present invention provides a cell as defined in claim 1. The cell may include the features of any one or more of dependent claims 2 to 7.

The present invention also provides a method as defined in claim 8. The method may include the features of dependent claims 9 and/or 10.

The invention is a solar cell having a nano-type structure.

### Brief Description of the Drawing

Figure 1 is a diagram of a nanostructure solar cell and its operation;
Figure 2 is an illustration of a nanostructure electron conductor of the solar cell;
Figure 3 is a diagram of increments of a nanostructure solar cell build; and
Figure 4 is a graph comparing the conversion efficiency of a nanostructure solar cell with that of another kind of solar cell.

### Description

The use of early generation solar photovoltaic (PV) technology or Si-based solar cells to generate clean electricity (as alternative to dirty fossil-fuel generated electricity) has not appeared cost competitive during the last several decades. Despite known and anticipated technology improvements and capacity increases, it still does not appear that solar cell technology will be cost competitive for electrical power generation for several more decades. Raffaelle et al disclose a solar cell comprising quantum dot-single wall carbon nanotube complexes used in polymeric solar cells (RAFFAELLE R P ET AL: "Quantum dot-single wall carbon nanotube complexes for polymeric solar cells", CONFERENCE RECORD OF THE THIRTY-FIRST IEEE PHOTOVOLTAIC SPECIALIST CONFERENCE (IEEE CAT. NO. 05CH37608) IEEE PISCATAWAY, NJ, USA, 3 January 2005 (2005-01-03), pages 74-77.) However, the present invention involving solar PV technology, based on nanostructure components and respective fabrication processes aimed to significantly increase conversion efficiency and reduce production costs, may allow a solar PV to become an economically viable form of a renewable alternative energy source within a timeframe shorter than several decades.

The present solar cell may maximize solar-to-electrical conversion efficiency through the use of fractal nanostructure electron conductors, and nanoparticles such as quantum dots (QDs) as an absorber. The cell may be fabricated on a flexible substrate. Combining these components may result in a flexible, low-cost, rugged solar sheet which can be produced with a simple, low temperature process.

The solar cell may be a result of precise engineering of consistent QD uniformity to match solar spectra, nanowire electron conductors, matching work functions / electron affinities, efficient hole-transport media, reduction or elimination of leakage / recombination, and low temperature process compatibility.

The solar cell includes, for instance, fractal nanowire-based electron conductors having a high surface area, significant transparency, good flexibility, and so on. The solar cell has a QD absorber, enhanced absorption cross-section, and has charge multiplication within the quantum dots, and is made with a simple additive process.

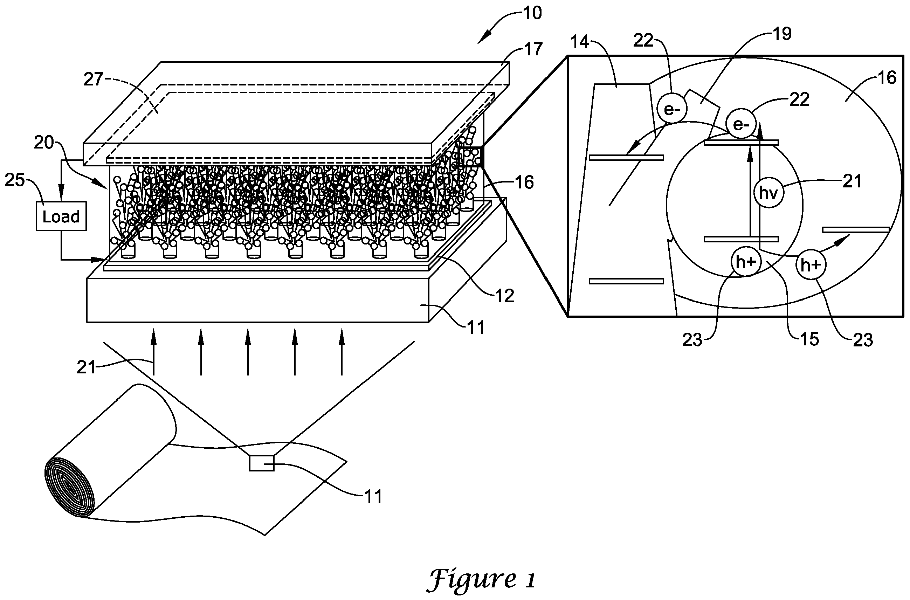

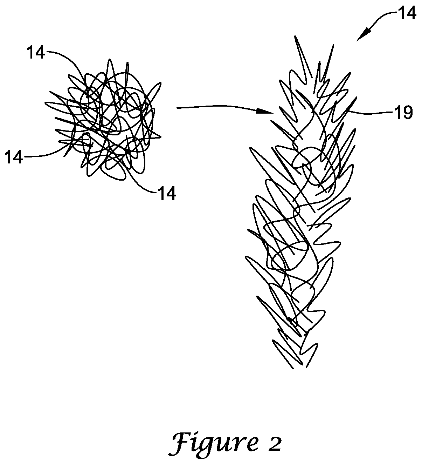

The solar cell is a nanostructure which includes significant characteristics such as a fractal architecture of nanostructure electron conductors 14 and a solid-state hole conductor 16, as indicated in Figures 1 and 2. An absorber 20 consists of quantum dots (QDs) 15 which are nanoparticles that can be shaped to be band-gap engineered so as to match a solar spectrum or spectra for optimized absorption. Band-gap engineering of the quantum dots, for a given element of material or compound, may be effected with geometrical design of the dots. Changing the shape of a quantum dot may affect the dot's band-gap. Band gaps of the QDs may be changed to maximize the solar cell's efficiency. For example, QDs may be round, oval, have points, and so on, for attaining particular energy levels to achieve particular band gaps.

QDs with enhanced absorption cross-sections may also maximize energy absorption within a very thin film, including a potential of multiple charge generation for each high-energy photon 21. Also, there is a fractal nanostructured high porosity electron conductors 14, which can provide maximized large surface areas for loading a solar absorber 20 of a given geometric area and thickness. The absorber elements 15 (i.e., QDs) may attach to a surface of the electron conductors 14. It is desirable to have fractal-like architecture for nanostructured electron conductors 14 to effect an optimized charge transport within the electron conductor. The electron conductors 14 may look like trees with branches 19 to attain greater surface.

Also, there is a complementary carrier conductor, such as a hole conductor 16, which is in intimate contact with the QDs 15 which are attached to the fractal nanoporous electron conductors 14, such that the conductor 16 provides efficient hole transfer and transport path. It is desirable to have the hole conductor 16 in a stable and solid state after completion of the solar cell fabrication. The material of the hole conductor 16 may be a polymer. These items may be formed and assembled with low-cost mass producible methods such as solution-based growth, self-assembly, additive process printing, and/or spraying, on a flexible substrate in a roll-to-roll (R2R) production line.

The present nanostructure-enabled solar cell (NESC) 10 may operate as indicated in Figure 1. Solar energy (photons 21 with energy hv) may be absorbed by quantum dots 15, which can be engineered to maximize absorption of a spectrum). Each solar photon 21 may generate one or more pairs, each pair including an electron (e-) 22 and a hole (h+) 23. The electrons 22 may be transferred to the fractal nanowire electron conductors 14 with structure appendages 19 consisting of a transparent electron conducting (EC) material (for example, TiO₂, ZnO,...), and the electrons 22 may be collected by a transparent negative electrode (anode) 11 from a contact plate 12 on which the electron conductors 14 are situated. The holes 23 may be transferred to a transparent organic polymer hole conducting (HC) material 16 and the holes 23 may eventually be collected by a reflective and protective positive electrode (cathode) 27. The electron conducting material of conductors 14 with structures 19 should be of a certain porous fractal nanostructure having a relatively large surface area (such that of nanowires or nanotubes 19) in order for more QDs 15 to be loaded and exposed to absorb as much solar energy as possible. Figure 2 shows an illustration of an electron conductor 14 having nanowires or nanotubes 19. The conductor 14 may resemble a "tree" having nanowires or tubes 19 which may resemble "branches". A group of "trees" with shorter "branches" may provide more surface area of a given volume, for holding more QDs 15.

The electron conductors 14 and hole conducting material 16 need to be in intimate contact with the QDs 15 for efficient charge transfer. The incident solar energy 21 may be considered as converted to electrical energy when the collected electrons 22 flow through an external conductive path 25 and recombine with the collected holes 23. The path 25 may be a load connected across the cathode 27 and anode 12.

An advantage of using nanowires 19 in the cell structure 10 may include the high porosity characteristic which maximizes absorber 20 loading with a resulting high absorption efficiency. Also, the fractal-type architecture of the nano electron conductors 14 with appendages of wires or tubes 19 may aid in an efficient carrier transport path and minimize carrier leakage.

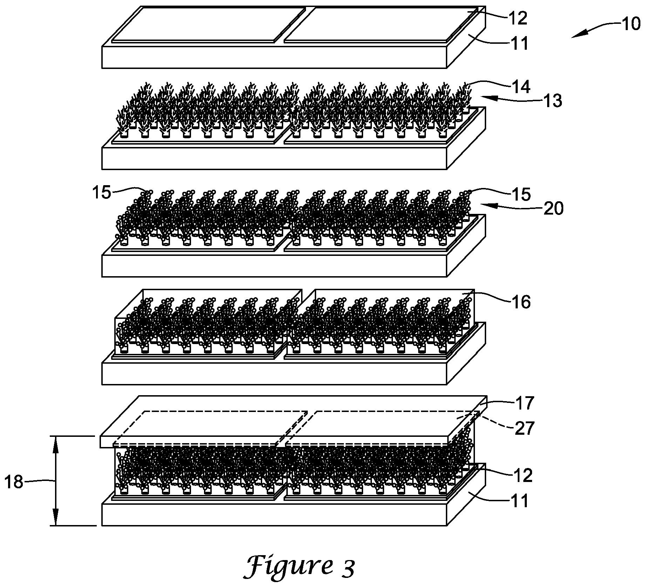

An approach for producing the present solar cell 10 may include an additive process flow with increments of the structure build as shown in Figure 3. One may start with a flexible substrate 11. A contact layer 12 may be added and situated on substrate 11. The layer may be transparent and conductive, and be seeding for nanowires 19 of electron conductors 14. Then a layer 13 of fractal nanowire electron conductors 14 may be added and situated on contact layer 12. The nanowires 19 may have diameters from tens to hundreds of nanometers (i.e., less than 500 nanometers) with lengths up to 20 microns. QDs 15 may be loaded to maximum levels of available space of the electron conductors and wires 14 and 19. A passivation coating (not shown) is applied on electron conductors 14 and 19 for reduced leakage. The passivation coating is a barrier to prevent the electrons from leaving the electron conductors 14 and recombining with holes of a hole conductor 16. Covering only of the open areas of the electron conductor 14 and 19 with the barrier material, and not areas of the QDs should be achieved. The hole+ conductor 16, may be applied in a liquid or gel form to the assembly. The liquid or gel material 16 may essentially immerse or permeate rather completely the nanoparticle CDs 15. Once applied, the liquid or gel form of the hole conductor 16 material may solidify for structural rigidity and containment. A top-reflector and contact interconnect (cathode) 27 and protective layer(s) 17 (Figure 1) may be connected to the hole conductor 16 and added to the assembly. Layer 17 or cathode 27 may include an anti-reflective coating. Layer 17 and cathode 27 may instead be one layer. A total thickness 18 of the present solar cell 10 assembly (Figure 3) may be less than one millimeter.

A nanostructure-enabled solar cell (NESC) 10 manufacturing process may suitably involve a low cost roll-to-roll manufacturing. The process may involve a minimum amount of and efficient use of materials, e.g., QD < 1mg/m². The desired aspects of the manufacturing or fabrication process may include a low-temperature setting and a lack of the need for a vacuum and ultra-clean environment. The present process may be compatible with using a flexible substrate 11 and a spraying/printing process for loading QDs 15 and a polymer conductor (i.e., conductor 16). The process for making the present cell 10 may leverage a manufacturing infrastructure developed for making displays (e.g., LCDs), which involves conductive transparent oxides or thin-films, and anti-reflective coatings.

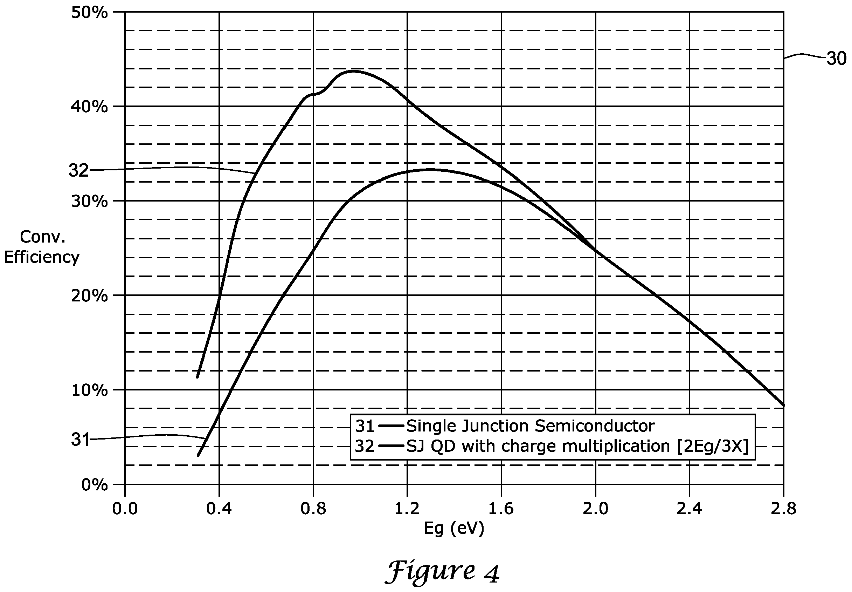

As noted herein, the use of quantum dots 15 in the cell 10 may allow bandgap engineering to match various solar spectra, provide significantly large absorption cross-sections for maximum efficiency, and result in potential charge multiplication to increase single-layer cell conversion efficiency by 30 percent as indicated by a graph 30 in Figure 4. The graph shows conversion efficiency (percent) versus bandgap (eV) of a single junction (semiconductor) solar cell, as shown by curve 31, and of an example of the present single junction quantum dot solar cell 10 (with charge multiplication), as shown by curve 32.

The nanostructure solar cell 10 may provide relatively significant power. Solar cell 10 may have high solar-to-electrical conversion efficiency. The cell may be a flexible, light weight and highly portable energy source with a power output performance in a range of 20-40 mW/cm². Cell 10 may provide NSC 40 mW/cm² continuous power under one-sun. One cm² cell may provide adequate power for wireless communication and operation of unattended ground sensors. One to two cm² cells may power a miniature atomic-clock. Two cm² cells may power a micro gas analyzer (MGA) for one analysis every 25 seconds (with a 1J/analysis goal). A laptop PC may be self-powered under the sun. Flexible solar sheets (of cell 10) covering a "power-helmet" may charge a cell-phone battery in less than 30 minutes.

Military applications may take advantage of the light weight of the present solar-to-electrical energy converter for soldiers' electronic field equipment (e.g., less battery and charging). The solar cell or converter 10 may provide more sustained power and longer life for unattended ground sensors compared to other like out-in-the-field power sources meeting similar power requirements. Nanostructures of the solar cell 10 may provide low cost and high efficiency for continuous power and integrated energy solutions for the soldiers' miniaturized systems.

In the present specification, some of the matter may be of a hypothetical or prophetic nature although stated in another manner or tense.

## Claims

1. A solar cell (10) comprising:
an electron conductor (14) having a fractal nanostructure;
an absorber (20) situated on the electron conductor, the absorber (20) comprising Quantum Dots (15);
a passivation coating applied to the electron conductor (14) without covering the Quantum Dots (15);
a hole conductor (16) in contact with the absorber;
a transparent anode (12) in electrical contact with the electron conductor; and
a cathode (27) in electrical contact with the hole conductor.

2. The cell of claim 1, wherein the quantum dots (15) of the absorber (20) are bandgap engineered for absorption of certain spectra of light.

3. The cell of claim 2, wherein:
the electron conductor (14) resembles a plurality of trees with branches that provide more surface area for a given volume for holding more quantum dots (15).

4. The cell of claim 1, wherein the hole conductor (16) is a polymer.

5. The cell of claim 1, further wherein:
the anode (12) is flexible and/or transparent and is disposed on a flexible and/or transparent substrate (11); and
the hole conductor (16) is connected to a cathode (27).

6. The cell of claim 1, wherein the electron conductor (14) includes:
a plurality of nanowires (19);
a plurality of Quantum Dots (15) loaded onto the plurality of nanowires (19);
the hole conductor (16) in contact with the nanoparticles; and
a second conductor (27) in contact with the hole conductor (16).

7. The cell of claim 6, wherein:
the nanowires (19) are fabricated from transparent conducting material;
the quantum dots bandgap engineered to match spectra of solar light which is a source of the photons (21) to be absorbed; and
the hole conductor (16) comprises a transparent organic polymer hole-conducting material; and at least one of the anode and cathode (12, 27) is transparent to solar light which is a source of photons being absorbed.

8. A method for solar-to-electrical energy conversion by using the solar cell of claim 1, comprising:
providing a transparent anode (12);
providing one or more nanoporous electron conductors having a fractal nanostructure (14) in contact with the anode (12), wherein the nanoporous electron conductors having fractal nanostructure resemble a plurality of trees with branches that provide more surface area for a given volume for holding more quantum dots (15);
loading the electron conductors with quantum dot absorbers (20);
applying a passivation coating to the electron conductors (14) without covering areas of the quantum dot absorbers;
providing a hole conductor (16) in contact with the absorber;
providing a cathode (27) in contact with the hole conductor;
providing photons (21) to the absorber; and
providing an electrical load (25) between the anode (12) and the cathode (27); and
wherein:
the photons (21) are absorbed by the quantum dots (15);
the photons (21) generate pairs of electrons (22) and holes (23);
the electrons move to the electron conductors;
the holes move to the hole conductor;
the electrons move from the electron conductors to the anode, through the load, to the cathode; and
rejoin the holes at the hole conductor adjacent the cathode.

9. The method of claim 8, wherein the quantum dots (15) are band-gap engineered to match spectra of solar light which is a source of the photons (21).

10. The method of claim 9, wherein an assembly comprising the anode (12), electron conductors (14), passivation coating, absorber (20), hole conductor(16), and cathode (27) for solar-to-electrical energy conversion, is made with a mass production method on a flexible substrate in a roll-to-roll production process.

## Patentansprüche

1. Solarzelle (10), umfassend:
einen Elektronenleiter (14) mit einer fraktalen Nanostruktur;
einen Absorber (20), der sich auf dem Elektronenleiter befindet, wobei der Absorber (20) Quantenpunkte (15) umfasst;
eine Passivierungsbeschichtung, die auf den Elektronenleiter (14) aufgebracht ist, ohne die Quantenpunkte (15) zu bedecken;
einen Löcherleiter (16) in Kontakt mit dem Absorber;
eine transparente Anode (12) in elektrischem Kontakt mit dem Elektronenleiter; und
eine Kathode (27) in elektrischem Kontakt mit dem Löcherleiter.

2. Zelle nach Anspruch 1, wobei die Quantenpunkte (15) des Absorbers (20) zur Absorption von bestimmten Spektren des Lichts bandlückenmodifiziert sind.

3. Zelle nach Anspruch 2, wobei:
der Elektronenleiter (14) einer Vielzahl von Bäumen mit Zweigen ähnelt, die für ein gegebenes Volumen mehr Oberfläche bereitstellen, um mehr Quantenpunkte (15) aufzunehmen.

4. Zelle nach Anspruch 1, wobei der Löcherleiter (16) ein Polymer ist.

5. Zelle nach Anspruch 1, wobei ferner:
die Anode (12) flexibel und/oder transparent ist und auf einem flexiblen und/oder transparenten Substrat (11) angeordnet ist; und
der Löcherleiter (16) mit einer Kathode (27) verbunden ist.

6. Zelle nach Anspruch 1, wobei der Elektronenleiter (14) einschließt:
eine Vielzahl von Nanodrähten (19);
eine Vielzahl von Quantenpunkten (15), mit denen die Vielzahl von Nanodrähten (19) beladen ist;
den Löcherleiter (16) in Kontakt mit den Nanopartikeln; und
einen zweiten Leiter (27) in Kontakt mit dem Löcherleiter (16).

7. Zelle nach Anspruch 6, wobei:
die Nanodrähte (19) aus transparentem leitenden Material gefertigt sind;
die Quantenpunktbandlücke modifiziert ist, um zu Spektren des Sonnenlichts zu passen, welche eine Quelle der zu absorbierenden Photonen (21) ist; und
der Löcherleiter (16) ein löcherleitendes Material aus transparentem organischen Polymer umfasst; und mindestens eine von der Anode und der Kathode (12, 27) transparent für Sonnenlicht ist, das eine Quelle der Photonen ist, die absorbiert werden.

8. Verfahren zur Umwandlung von Solarenergie in elektrische Energie durch Verwendung der Solarzelle gemäß Anspruch 1, umfassend:
Bereitstellen einer transparenten Anode (12),
Bereitstellen von einem oder mehreren nanoporösen Elektronenleitern mit einer fraktalen Nanostruktur (14) in Kontakt mit der Anode (12), wobei die nanoporösen Elektronenleiter mit einer fraktalen Nanostruktur einer Vielzahl von Bäumen mit Zweigen ähneln, die mehr Oberfläche für ein gegebenes Volumen bereitstellen, um mehr Quantenpunkte (15) aufzunehmen;
Beladen der Elektronenleiter mit Quantenpunktabsorbern (20) ;
Aufbringen einer Passivierungsbeschichtung auf die Elektronenleiter (14), ohne Bereiche der Quantenpunktabsorber zu bedecken;
Bereitstellen eines Löcherleiters (16) in Kontakt mit dem Absorber;
Bereitstellen einer Kathode (27) in Kontakt mit dem Löcherleiter;
Bereitstellen von Photonen (21) an den Absorber; und
Bereitstellen einer elektrischen Last (25) zwischen der Anode (12) und der Kathode (27);
und wobei:
die Photonen (21) von den Quantenpunkten (15) absorbiert werden;
die Photonen (21) Paare von Elektronen (22) und Löchern (23) generieren;
die Elektronen sich zu den Elektronenleitern bewegen;
die Löcher sich zu dem Löcherleiter bewegen;
die Elektronen sich von den Elektronenleitern zu der Anode, durch die Last, zu der Kathode bewegen; und
sich mit den Löchern an dem Löcherleiter angrenzend an die Kathode wieder vereinen.

9. Verfahren nach Anspruch 8, wobei die Quantenpunkte (15) bandlückenmodifiziert sind, damit sie zu Spektren des Sonnenlichts passen, welches eine Quelle der Photonen (21) ist.

10. Verfahren nach Anspruch 9, wobei eine Anordnung, welche die Anode (12), Elektronenleiter (14), Passivierungsbeschichtung, Absorber (20), Löcherleiter (16) und Kathode (27) umfasst, zur Umwandlung von Solarenergie in elektrische Energie nach einem Massenproduktionsverfahren auf einem flexiblen Substrat in einem Rolle-zu-Rolle-Produktionsprozess hergestellt wird.

## Revendications

1. Cellule solaire (10) comprenant :
un conducteur d'électrons (14) ayant une nanostructure fractale ;
un absorbeur (20) situé sur le conducteur d'électrons, l'absorbeur (20) comprenant des boîtes quantiques (15) ;
un revêtement de passivation appliqué au conducteur d'électrons (14) sans recouvrir les boîtes quantiques (15) ;
un conducteur de trous (16) en contact avec l'absorbeur ;
une anode transparente (12) en contact électrique avec le conducteur d'électrons ; et
une cathode (27) en contact électrique avec le conducteur de trous.

2. Cellule de la revendication 1, dans laquelle la bande interdite des boîtes quantiques (15) de l'absorbeur (20) est modifiée pour l'absorption de certains spectres de lumière.

3. Cellule de la revendication 2, dans laquelle :
le conducteur d'électrons (14) ressemble à une pluralité d'arbres avec des branches qui offrent plus de surface spécifique pour un volume donné afin de contenir plus de boîtes quantiques (15).

4. Cellule de la revendication 1, dans laquelle le conducteur de trous (16) est un polymère.

5. Cellule de la revendication 1, dans laquelle, en outre :
l'anode (12) est souple et/ou transparente et est disposée sur un substrat souple et/ou transparent (11) ; et
le conducteur de trous (16) est relié à une cathode (27) .

6. Cellule de la revendication 1, dans laquelle le conducteur d'électrons (14) comporte :
une pluralité de nanofils (19) ;
une pluralité de boîtes quantiques (15) chargées sur la pluralité de nanofils (19) ;
le conducteur de trous (16) en contact avec les nanoparticules ; et
un deuxième conducteur (27) en contact avec le conducteur de trous (16).

7. Cellule de la revendication 6, dans laquelle :
les nanofils (19) sont fabriqués à partir d'un matériau conducteur transparent ;
la bande interdite des boîtes quantiques est modifiée pour correspondre à des spectres de la lumière solaire qui est une source des photons (21) devant être absorbés ; et
le conducteur de trous (16) comprend un matériau conducteur de trous en polymère organique transparent ; et l'anode et/ou la cathode (12, 27) sont transparentes à la lumière solaire qui est une source de photons qui sont absorbés.

8. Procédé de conversion d'énergie solaire en énergie électrique au moyen de la cellule solaire de la revendication 1, comprenant les étapes suivantes :
se procurer une anode transparente (12) ;
disposer un ou plusieurs conducteurs d'électrons nanoporeux ayant une nanostructure fractale (14) en contact avec l'anode (12), les conducteurs d'électrons nanoporeux ayant une nanostructure fractale ressemblant à une pluralité d'arbres avec des branches qui offrent plus de surface spécifique pour un volume donné afin de contenir plus de boîtes quantiques (15) ;
charger les conducteurs d'électrons avec des absorbeurs à boîtes quantiques (20) ;
appliquer un revêtement de passivation aux conducteurs d'électrons (14) sans recouvrir les surfaces des absorbeurs à boîtes quantiques ;
disposer un conducteur de trous (16) en contact avec l'absorbeur ;
disposer une cathode (27) en contact avec le conducteur de trous ;
délivrer des photons (21) à l'absorbeur ; et
disposer une charge électrique (25) entre l'anode (12) et la cathode (27) ; et
dans lequel :
les photons (21) sont absorbés par les boîtes quantiques (15) ;
les photons (21) génèrent des paires d'électrons (22) et de trous (23) ;
les électrons se déplacent jusqu'aux conducteurs d'électrons ;
les trous se déplacent jusqu'au conducteur de trous ;
les électrons se déplacent des conducteurs d'électrons à l'anode, à travers la charge, jusqu'à la cathode ; et
rejoignent les trous au niveau du conducteur de trous adjacent à la cathode.

9. Procédé de la revendication 8, dans lequel la bande interdite des boîtes quantiques (15) est modifiée pour correspondre à des spectres de la lumière solaire qui est une source des photons (21).

10. Procédé de la revendication 9, dans lequel un assemblage comprenant l'anode (12), les conducteurs d'électrons (14), le revêtement de passivation, l'absorbeur (20), le conducteur de trous (16) et la cathode (27) pour la conversion d'énergie solaire en énergie électrique est réalisé avec un procédé de production de masse sur un substrat souple dans un procédé de production rouleau à rouleau.
